# DEMANDE DE BREVET EUROPEEN

(11) **EP 4 195 297 A1**
(43) Date de publication de la demande: **14.06.2023**
(21) Numéro de dépôt: 22209636.4
(22) Date de dépôt: 25.11.2022
(51) Int. Cl.: H01L 31/0443, H01L 31/048, H01L 31/05

(54) **MODULE PHOTOVOLTAÏQUE À DIODE DE DÉRIVATION IMPRIMÉE INTÉGRÉE**

(30) Priorité: 10.12.2021 FR 2113297
(71) Demandeur: Commissariat à l'énergie atomique et aux énergies alternatives, 75015 Paris (FR)
(72) Inventeur: GUERIN, Thomas, 38054 Grenoble cedex 09 (FR); CARIOU, Romain, 38054 Grenoble cedex 09 (FR); NOEL, Sébastien, 38054 Grenoble cedex 09 (FR)
(74) Mandataire: Cabinet Nony

(57) **Abrégé**

L'invention concerne un module photovoltaïque comportant :
- un substrat,
- une pluralité de structures photovoltaïques reliées électriquement entre elles s'étendant sur le substrat et comportant chacune au moins une cellule photovoltaïque, et
- une structure multicouche de connexion électrique prise en sandwich entre le substrat et la pluralité de structures photovoltaïques formant au moins une diode de dérivation pour chaque structure photovoltaïque,
chaque diode de dérivation comportant :
- deux électrodes reliées électriquement à des bornes de polarité opposées de la structure photovoltaïque correspondante, l'une au moins des deux électrodes s'étendant au moins partiellement sous la structure photovoltaïque correspondante, et
- une portion semi-conductrice en contact avec les deux électrodes par deux surfaces distinctes.

## Description

La présente invention concerne un module photovoltaïque comportant une diode de dérivation imprimée intégrée et son procédé de fabrication. L'invention a également trait à l'utilisation d'un tel module photovoltaïque.

### Domaine technique

Un module photovoltaïque est constitué d'une succession de cellules photovoltaïques électriquement connectées entre elles et encapsulées dans un empilement de matériaux de type polymères et/ou verre. Les cellules sont connectées traditionnellement par une pièce métallique, généralement des fils ou des rubans. Les cellules photovoltaïques sont classiquement protégées par groupes par des diodes de dérivation (classiquement appelée diode by-pass) rapportées qui assurent le passage de courant en cas de casse ou d'ombrage d'une ou plusieurs cellules d'un groupe, et limitent ainsi les pertes de puissance. Traditionnellement, de telles diodes sont déportées et confinées à l'écart du circuit électrique principal, ce qui fait perdre de la surface au détriment des cellules photovoltaïques.

Il est également connu de protéger individuellement chaque cellule photovoltaïque par une diode de dérivation (autrement appelée diode « by-pass ») rapportée. Dans ces cas, les diodes de dérivation sont traditionnellement proches des cellules photovoltaïques en question, par exemple à côté, notamment dans le domaine spatial où elles peuvent être intégrées dans un coin découpé de la cellule photovoltaïque, ou en dessous, notamment dans le domaine des modules stratosphériques. Il est également connu de les intégrer dans une structure multicouche. Nous pouvons citer à cet égard, la demande de brevet US20050072457 décrivant un module comportant, de bas en haut, un substrat 24, une structure multicouche à haute conductivité thermique 40, et des structures photovoltaïques comportant chacune une structure intermédiaire sur laquelle est agencée une cellule photovoltaïque. Les structures intermédiaires comportent une diode de dérivation en silicone préfabriquée du commerce de faible étendue s'étendant entre les cellules et le substrat. La demande de brevet US 20090025778 décrivant un dispositif photovoltaïque comportant une diode by-pass s'étendant entre les cellules et le substrat et des électrodes et des barres de jonction reliant les cellules à la diode de dérivation et entre a également trait à une diode de dérivation rapportée.

Il est également connu d'avoir des modules photovoltaïques comportant une structure électrique imprimée sous les cellules photovoltaïques, comportant sous chaque cellule photovoltaïque une électrode imprimée en connexion électrique avec la cellule photovoltaïque, les cellules photovoltaïques étant connectés les unes avec les autres par des interconnections entre chaque cellule et l'électrode connectée électriquement à la cellule en aval.

Les demandes de brevet KR 10 2013 01349847 et KR10 2013 0139493 décrivent des cellules photovoltaïques composées de structures verticales comportant de bas en haut en se superposant un substrat comportant deux électrodes séparées entre elles par un isolant, une diode de dérivation et une cellule photovoltaïque. L'ensemble formé de la diode de dérivation et de la cellule photovoltaïque se superpose à une des électrodes du substrat. Les électrodes du substrat sont reliées électriquement par des fils électriques ou pistes conductrices à la diode et à la cellule par l'intermédiaire d'électrodes de connexions additionnelles. Le substrat, la diode et la cellule sont fabriqués séparément les uns des autres et assemblés par des couches de jonction.

Il est connu de la demande de brevet US 2008/0149173 une structure à semi-conducteur comportant une superposition d'un substrat, d'une électrode, de plusieurs cellules photovoltaïques en série et d'une diode by-pass, la superposition étant formée par dépôt de couches successives. La diode by-pass est électriquement en dérivation des cellules photovoltaïques reliées en série entre elles.

Il est connu de la demande internationale WO2021123575 un générateur solaire pour satellite comportant plusieurs modules photovoltaïques montés sur un support flexible. Les modules comportent un circuit imprimé comportant un support isolant et des pistes conductrices sur une face du support ainsi que des chaines de cellules photovoltaïques en série montés sur la face portant les pistes et connectées aux pistes pour établir une connexion électrique entre les chaines. Un tel générateur peut comporter une diode de blocage par module.

La demande de brevet EP 3 147 952 décrit un générateur solaire comportant un support flexible portant un réseau de cellules solaires aménagées selon différentes lignes transversales de cellules montées en série et des conducteurs électriques de transfert indépendants pour chaque ligne transversale. Le générateur comporte également une diode de blocage sur chaque ligne en extrémité proximale du générateur solaire montée espacée des cellules. Les conducteurs électriques peuvent être formés de pistes conductrices gravées sur un circuit imprimé flexible monocouche ou multicouche. Les conducteurs électriques peuvent être pris en sandwich entre deux couches d'isolant dans le circuit imprimé.

Il existe un besoin pour bénéficier d'un module photovoltaïque qui soit à la fois de bon rendement, de faible épaisseur, facile à mettre à œuvre et présentant une protection électrique individuelle ou par groupe des cellules photovoltaïque en cas de casse ou ombrage d'une ou plusieurs cellules.

### Exposé de l'invention

L'invention répond à ce besoin à l'aide d'un module photovoltaïque comportant :
- un substrat,
- une pluralité de structures photovoltaïques reliées électriquement entre elles s'étendant sur le substrat et comportant chacune au moins une cellule photovoltaïque, et
- une structure multicouche de connexion électrique prise en sandwich entre le substrat et la pluralité de structures photovoltaïques formant au moins une diode de dérivation pour chaque structure photovoltaïque,
   chaque diode de dérivation comportant :
   - deux électrodes reliées électriquement à des bornes de polarité opposées de la structure photovoltaïque correspondante, l'une au moins des deux électrodes s'étendant au moins partiellement sous la structure photovoltaïque correspondante, et
   - une portion semi-conductrice en contact avec les deux électrodes par deux surfaces distinctes.

Par « *bornes de polarité opposées* », on comprend une anode et une cathode d'extrémité de la structure photovoltaïque.

Pr « *diode de dérivation* », on comprend une diode autrement appelée diode by-pass qui permet de protéger la structure photovoltaïque de la surchauffe, notamment engendrée par le dysfonctionnement ou l'ombrage d'une ou plusieurs cellules de la structure photovoltaïque. Une telle diode de dérivation est par définition connecté en parallèle de la structure photovoltaïque, mais avec une polarité opposée à la structure photovoltaïque. En fonctionnement normal, la structure photovoltaïque sera passante et la diode de dérivation sera polarisée en inverse de sorte à bloquer le courant. Cependant, lorsque la structure photovoltaïque est polarisée en inverse en raison d'une inadéquation du courant de court-circuit entre plusieurs cellules connectées en série (ombrage d'une ou plusieurs cellules notamment) alors la diode de dérivation est passante.

Le fait d'intégrer la ou les diode(s) de dérivation entre les structures photovoltaïques et le substrat permet d'avoir un gain d'espace utile à la surface du module pour les structures photovoltaïques. Cela permet une plus grande puissance récoltée par unité de surface (W/m²).

La présence de la ou les diode(s) de dérivation dans la structure multicouche de connexion électrique peut permettre de s'affranchir d'isolant dans cette dernière du fait de l'isolation apportée par la portion semi-conductrice.

Dans le présent module, la ou les diode(s) diode de dérivation étant interne(s) au module, elle(s) est (sont) protégée(s) vis-à-vis de l'environnement, ce qui permet notamment l'utilisation de diodes de dérivation de type organique.

Un tel module permet de limiter le nombre de soudures ou l'intégration d'éléments rapportés dans le module, ce qui réduit le nombre d'étapes de fabrication nécessaire et en facilite ainsi la fabrication.

### Substrat

Le substrat peut être flexible ou rigide.

Le substrat peut être en un matériau polymère, notamment en polyimide (Kapton) ou PolyEtherEtherKetone (PEEK).

Le substrat peut présenter une épaisseur comprise entre 25 µm et 8 cm, mieux entre 25 µm et 1 cm, encore mieux entre 25 µm et 200 µm, notamment pour un substrat flexible.

Le substrat comporte de préférence une surface, notamment plane, sur laquelle s'étend la structure multicouche de connexion électrique.

De préférence, le substrat est en un matériau électriquement isolant.

### Structure photovoltaïque

Au moins une structure photovoltaïque peut comporter une unique cellule photovoltaïque. Les diodes de dérivation permettent alors de protéger chaque cellule individuellement.

Au moins une structure photovoltaïque peut comporter un montage en série de plusieurs cellules photovoltaïques, l'une des deux électrodes de la diode de dérivation correspondante étant reliée électriquement à la première cellule photovoltaïque du montage en série, l'autre des deux électrodes de la diode de dérivation correspondante étant reliée électriquement au moins à la dernière cellule photovoltaïque du montage en série. La diode de dérivation associée à la structure photovoltaïque permet alors de protéger la série de cellules lorsque l'une d'entre elles est en polarisation inverse.

Les structures photovoltaïques peuvent toutes comporter le même nombre de cellules photovoltaïques.

Les structures photovoltaïques peuvent être toutes identiques. En variante, au moins deux structures photovoltaïques sont différentes, notamment présentent un nombre de cellules photovoltaïques différent ou des cellules photovoltaïques ayant des caractéristiques différentes.

De préférence, la ou les cellules photovoltaïques de chaque structure photovoltaïque sont des cellules multi-jonctions à matériaux semi-conducteur de type III-V, notamment des cellules photovoltaïques à triples jonctions GaInP/GaAs/Ge. En variante, la ou les cellules photovoltaïques sont des cellules à simple jonction, notamment en couche mince CIGS, en silicium, en tellurure de cadmium (CdTe) ou pérovskite.

De préférence, les structures photovoltaïques sont toutes de même épaisseur.

L'épaisseur des structures photovoltaïques, notamment des cellules photovoltaïques, peut être supérieure ou égale à 10 µm. L'épaisseur de la structure photovoltaïque, notamment de la ou des cellules photovoltaïques, peut être inférieure ou égale à 200 µm.

### Structure multicouche de connexion électrique

De préférence, la structure multicouche de connexion électrique s'étend directement sur le substrat.

La structure multicouche de connexion électrique peut être imprimée ou déposée autrement sur le substrat, notamment formée par impression, pulvérisation cathodique, dépôt laser pulsé, dépôt chimique en phase vapeur (CVD) ou (PECVD) ou encore dépôt de couche atomique (ALD).

De préférence, la structure multicouche de connexion électrique est d'épaisseur sensiblement uniforme sur le substrat.

Les deux électrodes des diodes de dérivation peuvent être en un métal conducteur, par exemple aluminium, cuivre, molybdène, argent ou or, ou un oxide conducteur, notamment en oxyde d'indium-étain (ITO) ou oxyde de zinc dopée à l'aluminium (AZO), ou un semi-conducteur organique, notamment en poly(3,4-éthylènedioxythiophène) (PEDOT) ou poly(triaryl amine) (PTAA).

Les deux électrodes des diodes de dérivation sont, de préférence, en un même matériau. En variante, une des deux électrodes des diodes de dérivation est en un premier matériau conducteur notamment choisi aluminium, cuivre, molybdène, argent ou or, ou un oxide conducteur, notamment en oxyde d'indium-étain (ITO) ou oxyde de zinc dopée à l'aluminium (AZO) et l'autre des deux électrodes des diodes de dérivation est en un deuxième matériau conducteur différent du premier matériau conducteur, notamment en or ou en un semi-conducteur organique, tel que le poly(3,4-éthylènedioxythiophène) (PEDOT) ou poly(triaryl amine) (PTAA).

Les deux électrodes des diodes de dérivation peuvent chacune présenter, au niveau de la diode de dérivation, une épaisseur comprise entre 0,1 µm et 100 µm, mieux entre 0,2 µm et 15 µm.

Les portions semi-conductrices des diodes de dérivation peuvent comporter un semi-conducteur organique ou Métal-oxyde, notamment en oxyde de zinc intrinsèque (ZnO:I), oxyde de titane (TiO₂), oxyde de zirconium (ZrO₂), dioxyde d'étain (SnO₂) ou encore germanium amorphe (a-Ge) ou silicium amorphe (a-Si).

Les portions semi-conductrices peuvent chacune présenter une épaisseur comprise entre 0,1 µm et 100 µm, mieux entre 0,1 et 5 µm.

Les diodes de dérivation peuvent présenter une épaisseur totale comprise entre 0,3 µm et 500 µm, mieux entre 0,5 µm et 50 µm.

De préférence, les portions semi-conductrices sont chacune prise en sandwich entre les deux électrodes de la même diode de dérivation pour former un empilement. Les portions semi-conductrices peuvent être chacune en contact avec une des électrodes par une première surface sensiblement parallèle à un plan d'extension des structures photovoltaïques, et en contact avec l'autre des électrodes par une deuxième surface opposée à la première. Les empilements peuvent s'étendre chacun selon une surface parallèle au plan des structures photovoltaïques supérieure ou égale à 50%, mieux supérieure ou égale à 80%, encore mieux supérieure ou égale à 90%, de la surface de la structure photovoltaïque. Une telle extension permet d'avoir une diode de dérivation de large surface, ce qui facilite la dissipation thermique de la diode de dérivation en fonctionnement.

En variante, dans chaque diode de dérivation, la portion semi-conductrice est juxtaposée avec les deux électrodes. Les portions semi-conductrices peuvent être chacune en contact avec une des électrodes par une première surface, notamment sensiblement perpendiculaire au plan d'extension des structures photovoltaïques, et en contact avec l'autre des électrodes par une deuxième surface opposée à la première.

Les deux électrodes de chaque diode de dérivation peuvent être séparées entre elles uniquement par la portion semi-conductrice de la diode de dérivation correspondante. En variante, les diodes de dérivation peuvent comporter chacune au moins une portion isolante agencée pour séparer, avec la portion semi-conductrice les deux électrodes entre elles.

De préférence, les portions semiconductrices présentent chacune au moins une zone épaissie pour séparer les deux électrodes de la diode de dérivation correspondante entre elles au niveau du substrat et/ou de la surface de la structure multicouche de connexion électrique portant les structures photovoltaïques.

De préférence, pour chaque diode de dérivation, une des deux électrodes est reliée à la structure photovoltaïque correspondante par au moins un interconnecteur métallique, notamment un fil ou un ruban métallique.

Pour chaque diode de dérivation, une des deux électrodes peut être en contact direct avec la face arrière la structure photovoltaïque correspondante, notamment de la cellule photovoltaïque de la structure photovoltaïque ou de la première cellule photovoltaïque de la structure photovoltaïque. En variante, le module peut comporter une couche conductrice séparant, pour chaque diode de dérivation, une des deux électrodes de la structure photovoltaïque, notamment une couche métallique rapportée ou directement formée sur l'électrode ou une colle électriquement conductrice, notamment à base de silicone ou époxy. La couche conductrice peut comporter une épaisseur comprise entre 10 à 100 µm, préférentiellement 20 à 80µm. De préférence, pour chaque diode de dérivation, une des deux électrodes est en contact direct ou indirect avec une anode de la structure photovoltaïque correspondante.

De préférence, pour chaque diode de dérivation, une des deux électrodes est reliée à la structure photovoltaïque correspondante par un interconnecteur métallique tel que décrit précédemment et l'autre des deux électrodes est en contact direct ou indirect, tel que décrit précédemment, avec la structure photovoltaïque correspondante.

De préférence, une des deux électrodes de la diode de dérivation pour chaque structure photovoltaïque, est une extension de l'une des deux électrodes de la diode de dérivation pour une structure photovoltaïque antérieur ou suivante.

Au moins deux des structures photovoltaïques peuvent être reliées électriquement entre elles en série. Dans ce cas, l'électrode reliée à l'une des deux structures photovoltaïques par un interconnecteur métallique peut être une extension de l'électrode en contact direct avec l'autre des deux structures photovoltaïques ou séparés de l'autre des structures photovoltaïques par une couche conductrice.

Au moins deux des structures photovoltaïques peuvent être reliées électriquement entre elles en parallèle. Dans ce cas, l'électrode reliée à l'une des deux structures photovoltaïques par un interconnecteur métallique peut être une extension de l'électrode reliée à l'autre structure photovoltaïque correspondante par un interconnecteur métallique ou de l'électrode en contact direct ou indirect avec une des deux structures photovoltaïques peut être une extension de de l'électrode en contact direct ou indirect avec l'autre des deux structures photovoltaïques.

De préférence, chaque diode de dérivation est configurée pour supporter un courant au moins égal au maximum de courant susceptible de parcourir la structure photovoltaïque qu'elle protège. De préférence, chaque diode de dérivation accepte un courant supérieur ou égal à 0,5A.

De préférence, chaque diode de dérivation est configurée pour laisser passer le courant lorsque la cellule photovoltaïque ou une des cellules photovoltaïques de la structure photovoltaïque correspondante reçoit une intensité lumineuse inférieure ou égale à 5% de l'intensité lumineuse reçue par les autres cellules photovoltaïques.

La structure multicouche de connexion électrique comportant une diode de blocage pour une pluralité de structures photovoltaïques montées entre elles en série, la diode de blocage comportant deux électrodes de blocage reliées électriquement respectivement à des bornes de polarité opposés de la première et de la dernière structure photovoltaïque de la série, et une portion semi conductrice de blocage en contact avec les deux électrodes de blocage par des surfaces différentes.

Par « *diode de blocage* », on comprend une diode permettant le passage du flux de courant d'une série de structures photovoltaïques vers une batterie ou un régulateur de charge mais empêche le flux de courant de la batterie ou du régulateur de charge vers la série, empêchant ainsi la décharge de la batterie dans les structures photovoltaïques, notamment en l'absence de luminosité lorsque les structures photovoltaïques sont polarisées en inverse.

Le module comporte, de préférence, au moins une structure de protection encapsulant les structures photovoltaïques et/ou la structure multicouche de connexion électrique. La structure de protection peut comporter un matériau d'encapsulation polymère, notamment en un silicone transparent, préférentiellement à faible taux de dégazage, par exemple de l'éthylène-acétate de vinyle (EVA) ou du polyoxyéthylène (POE) ou tous autres matériaux traditionnellement utilisés comme encapsulant de module PV. La structure de protection peut également comporter une plaque de couverture protégeant la surface extérieure du module de l'extérieur, notamment une plaque en verre ou en polymère, par exemple en polyétheréthercétone (PEEK) ou un film fluoré.

L'invention a également trait à un procédé de fabrication d'une structure multicouche de connexion électrique s'étendant sur un substrat tel que décrit précédemment configurée pour recevoir des structures photovoltaïques, comportant le dépôt des couches successives de la structure multicouche de connexion électrique sur le substrat pour former une pluralité de diodes de dérivation.

L'invention a également trait à un procédé de fabrication d'un module tel que décrit précédemment comportant :
- le dépôt des couches successives de la structure multicouche de connexion électrique sur le substrat pour former une pluralité de diodes de dérivation
- l'adjonction de structures photovoltaïques sur la structure multicouche de connexion électrique de sorte que les structures photovoltaïques se superposent chacune à une des diodes de dérivation,
- la liaison électrique, notamment par des interconnecteurs métalliques, des structures photovoltaïques entre elles, notamment par l'intermédiaire des diodes de dérivation, de sorte que les diodes soient passantes lorsque la structure photovoltaïque correspondante ne l'est pas.

L'invention a également pour objet l'utilisation du module tel que décrit précédemment pour la fabrication de panneaux photovoltaïques, notamment destinés à une utilisation spatiale ou terrestre.

De préférence, les structures photovoltaïques comportent une unique cellule photovoltaïque et le module est utilisé pour la fabrication de panneaux photovoltaïques destinés à un usage spatial. Le module peut être utilisées pour la fabrication des générateurs solaires de satellite.

### Brève description des dessins

L'invention pourra être mieux comprise à la lecture de la description détaillée qui va suivre, d'exemples de mise en œuvre non limitatifs de celle-ci, et à l'examen de dessin annexé, sur lequel :
[Fig 1] représente schématiquement en vue du dessus un module photovoltaïque,
[Fig 2] représente schématiquement en vue du dessus la structure multicouche de connexion électrique imprimée sur le substrat de la figure 1,
[Fig 3] est une coupe partielle selon III-III du module photovoltaïque de la figure 1,
[Fig 4] représente schématiquement le circuit électronique du module lorsque les structures photovoltaïques sont en fonctionnement,
[Fig 5] représente schématiquement en coupe une variante de module lorsqu'une des structures photovoltaïques est en polarisation inverse,
[Fig 6] représente schématiquement en coupe une variante de module,
[Fig 7] représente schématiquement en coupe une variante de module,
[Fig 8] représente schématiquement en coupe une variante de module, et
[Fig 9] représente schématiquement en coupe une variante de module.

### Description détaillée

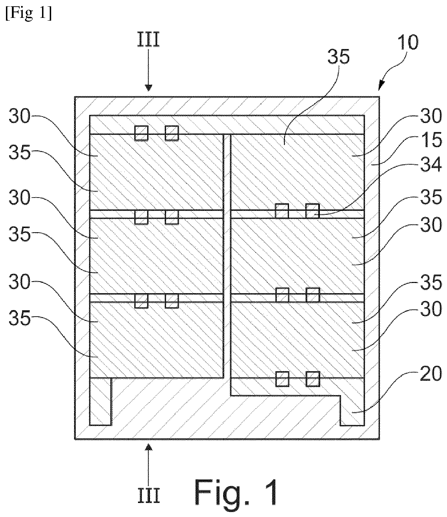

On a illustré sur les figures 1 à 3 un module photovoltaïque 10 comportant un substrat 15 flexible ou rigide fonctionnalisé sur une de ses surfaces planes par le dépôt, notamment par impression, d'une structure multicouche de connexion électrique 20 de préférence d'épaisseur constante sur laquelle des structures photovoltaïques 30 formées chacune d'une unique cellule photovoltaïque 35 sont agencées.

Le substrat 15 est en un matériau polymère isolant électrique, par exemple en polyimide ou PEEK (polyétheréthercétone).

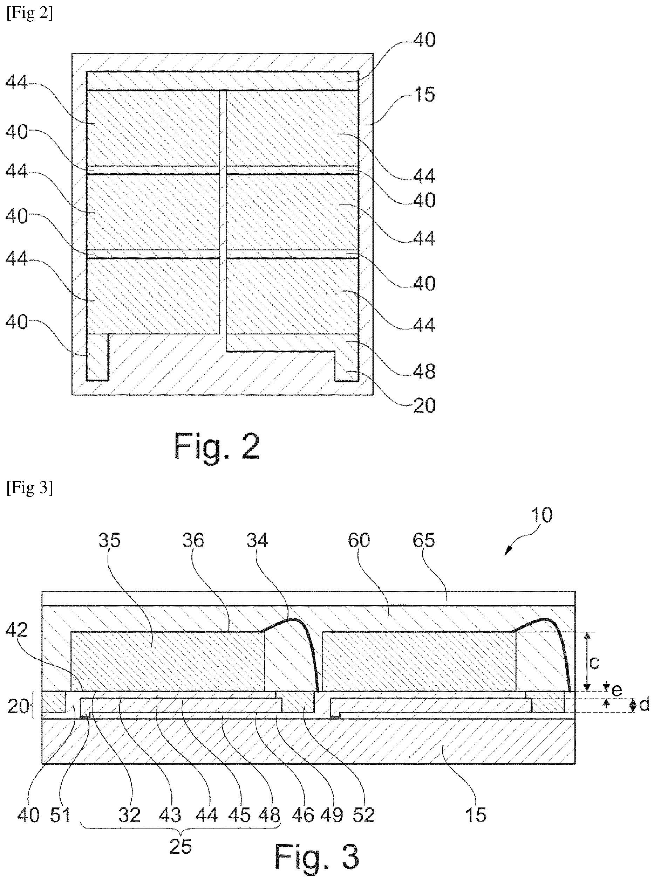

Comme cela est illustré sur la figure 3, la structure multicouche de connexion électrique 20 comporte, pour chaque cellule photovoltaïque, une diode de dérivation 25 formée de l'empilement entre la cellule 35 et le substrat 15 de deux électrodes 40 et 48 séparées par une portion semi-conductrice 44. L'électrode 48 est formé d'une extension de l'électrode 40 de la cellule photovoltaïque suivante de la série. De préférence, la portion semi-conductrice 44 est en contact avec les deux l'électrodes 40 et 48 par ses surfaces supérieure 45 inférieure 49 respectivement. L'électrode 40 s'étend au moins partiellement entre la cellule photovoltaïque 35 et le substrat 15 et est reliée électriquement à la structure photovoltaïque 30, notamment à l'anode de la cellule, par contact direct ou indirect. Le contact peut se faire directement entre la face supérieure 42 de l'électrode 40 et la face inférieure de la cellule 32 ou indirectement par l'intermédiaire d'une couche conductrice (non illustrée) s'étendant entre l'électrode 40 et la structure photovoltaïque 30, notamment une couche métallique rapportée ou directement formée sur l'électrode 40 ou une colle électriquement conductrice, notamment à base de silicone ou époxy. L'électrode 48 s'étend entre la portion semi-conductrice 44 et le substrat 15.

Les cellules photovoltaïques 35 sont reliées électriquement entre elles en série par des connecteurs électriques 34, notamment des rubans ou fils conducteurs, reliant la face supérieure des cellules 36, notamment la cathode des cellules, à l'électrode 40 de la structure multicouche de connexion électrique 20 associé à la structure photovoltaïque suivante dans la série, notamment reliée à l'anode de la cellule suivante. De préférence, toutes les cellules photovoltaïques sont identiques, mais il pourrait en être autrement.

L'épaisseur c des cellules photovoltaïque est de préférence inférieure ou égale à 150 µm.

Les cellules photovoltaïques peuvent être tout type de cellule photovoltaïque, notamment des cellules multi-jonctions à matériaux semi-conducteurs de type III-V, par exemple des cellules triples jonctions GaInP/GaAs/Ge.

La portion semi conductrice 44 sépare totalement, avec une portion d'isolant 52, les deux électrodes 40 et 48 entre elles de sorte que le courant qui veut passer de l'une à l'autre des électrodes 40 et 48 ne puisse le faire que par l'intermédiaire de la portion semi-conductrice 44 ou de la cellule photovoltaïque 35.

La couche semi-conductrice 44 peut présenter une extension verticale 51 permettant de séparer les électrodes 40 et 48 entre elles au niveau du substrat 15.

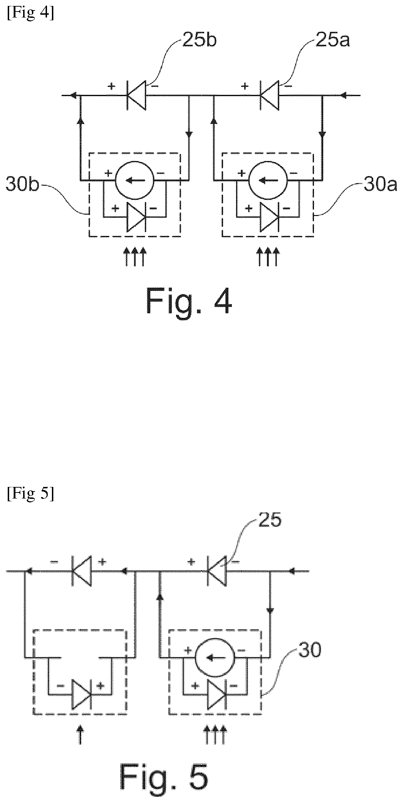

Comme cela est illustré sur les schémas électriques des figures 4 et 5, les portions semi-conductrices 44 sont chacune orientées de sorte à être bloquante quand la structure photovoltaïque 30 correspondante est passante, comme cela est illustré sur la figure 4 sur laquelle les deux structures 30a et 30b sont passante, et passante quand la structure photovoltaïque 30 correspondante est polarisée en inverse, comme cela est illustré sur la figure 5 pour la diode de dérivation 25b lorsque la structure photovoltaïque 30b est ombragée et donc polarisé en inverse . La diode de dérivation est configurée pour fonctionner avec un courant au moins égal au maximum de courant parcourant la cellule photovoltaïque qu'elle protège. De préférence, chaque diode de dérivation accepte un courant supérieur ou égal à 0,5A.

Les premières et deuxièmes électrodes 40 et 48 peuvent être en un métal, notamment en aluminium, cuivre, molybdène, argent ou or, ou un oxide conducteur, notamment en oxyde d'indium-étain (ITO) ou oxyde de zinc dopée à l'aluminium (AZO), ou un semi-conducteur organique, notamment en poly(3,4-éthylènedioxythiophène) (PEDOT) ou poly(triaryl amine) (PTAA).

Les premières et deuxièmes électrodes 40 et 48 peuvent présenter au niveau de l'empilement formant la diode de dérivation une épaisseur e comprise entre 0,1 µm et 100 µm, mieux entre 0,5 et 10 µm.

Les portions semi-conductrices 44 peuvent comporter un semi-conducteur organique, ou un oxyde-métallique, notamment en oxyde de zinc dopé(ZnO), en oxyde de titane (TiO₂), en oxyde de zirconium (ZrO₂), dioxyde d'étain (SnO₂), ou encore germanium amorphe (a-Ge) ou silicium amorphe (a-Si).

Les portions semi-conductrices 44 peuvent présenter une épaisseur d comprise entre 0,1 µm et 100 µm, mieux entre 0,15 et 2 µm.

Les empilements s'étendent préférentiellement chacun selon une surface parallèle au plan des structures photovoltaïques 30 sensiblement égale à la surface de la structure photovoltaïque. Une telle disposition sous les structure photovoltaïque 30 permet de limiter l'échauffement de la diode de dérivation 25 en facilitant la dissipation thermique de la diode 25 en fonctionnement.

Comme cela est illustré sur la figure 3, les cellules photovoltaïques 30 et/ou la structure multicouche de connexion électrique 20 peuvent être encapsulées dans une couche de protection 60 en polymère, notamment en EVA ou POE et peut comporter, en surface, une plaque de protection 65, notamment en verre ou en PEEK, ou un film fluoré.

Un tel module photovoltaïque 10 est fabriqué par dépôt, notamment impression, d'une ou plusieurs couches successives empilées pour former la structure multicouche de connexion électrique 20 sur le substrat 15 telle que décrit précédemment. Le dépôt peut se faire par des méthodes :
- d'impression sans contact, telles que la sérigraphie (Screen printing) ou l'impression par jet d'encre (Ink jet printing, le revêtement par fente (Slot die coating), la pulvérisation cathodique (Spray coating) ou le dépôt laser pulsé, et/ou
- d'impression par contact, telles que l'impression par gravure, et/ou
- de dépôt de couche, notamment le dépôt chimique en phase vapeur (CVD) assisté par plasma (PECVD) ou le dépôt de couche atomique (ALD).

Une fois la structure multicouche de connexion électrique 20 réalisée, les cellules photovoltaïques 35 sont ajoutées au repère sur les diodes de dérivation 25 de la structure multicouche de connexion électrique 20 au contact direct de l'électrode 40 en surface correspondante ou séparées de cette dernière par une couche conductrice comme décrit précédemment. Les surfaces supérieures des cellules 30 sont reliées électriquement par les connecteurs 34 à l'électrode en surface 40 s'étendant sous la cellule en aval de la série. La couche de protection 60 est ensuite ajoutée, ainsi que la plaque de protection.

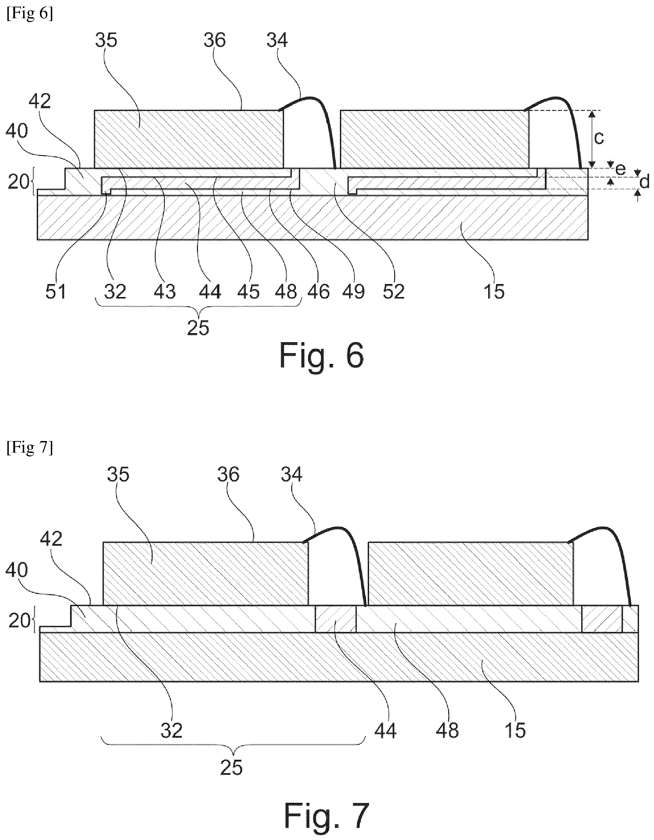

Les exemples des figures 6 et 7 diffèrent de celui de la figure 3 par l'agencement des différents éléments de la structure multicouche de connexion électrique 20.

Dans l'exemple de la figure 6, la structure multicouche de connexion électrique 20 est dépourvue de portion d'isolant entre les différentes électrodes de ladite structure 20. Les différentes électrodes sont séparées entre elles uniquement par la couche semi-conductrice 44, cette dernière comportant deux extensions verticales 51 séparant les deux électrodes 40 et 48 respectivement au niveau du substrat 15 et au niveau de la surface supérieure de la structure multicouche de connexion électrique 20.

Dans l'exemple de la figure 7, la structure multicouche de connexion électrique 20 est dépourvue de portion d'isolant entre les différentes électrodes de ladite structure multicouche de connexion électrique 20 et la diode de dérivation 25 n'est pas formée d'un empilement mais d'une juxtaposition d'électrodes sous les cellules et de portions semi-conductrice entre les cellules.

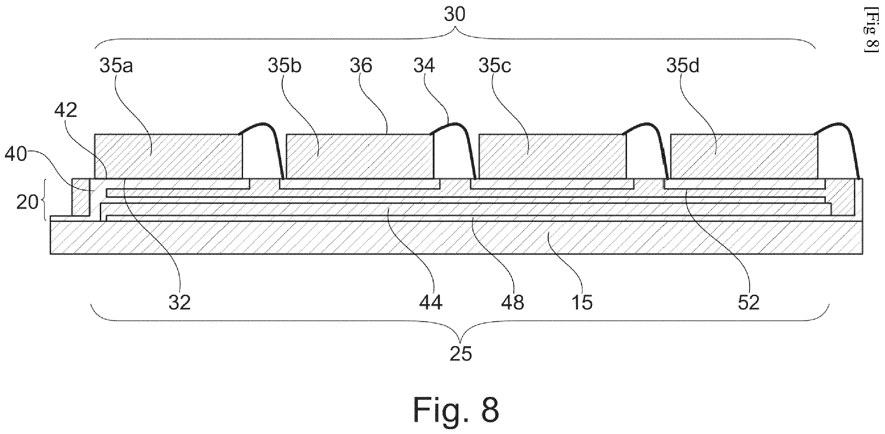

L'exemple de la figure 8 diffère de celui de la figure 3 en ce que la diode de dérivation 25 permet de protéger une structure photovoltaïque 30 comportant une pluralité de cellules photovoltaïques 35a à 35d montées en série les unes par rapport aux autres. L'électrode 40 de la diode 25 en surface de la structure multicouche de connexion électrique 20 est reliée électriquement à la première cellule de la série 35a et l'électrode 48 est reliée électriquement à la dernière cellule de la série 35d par l'intermédiaire d'un conducteur électrique 34. La portion semi-conductrice 44 s'étend entre les deux électrodes 40 et 48 sous toute la surface de la structure photovoltaïque 30. Les électrodes des cellules intermédiaire 35b et 35c sont isolées des électrodes 40 et 48 par une ou plusieurs portions d'isolant 52.

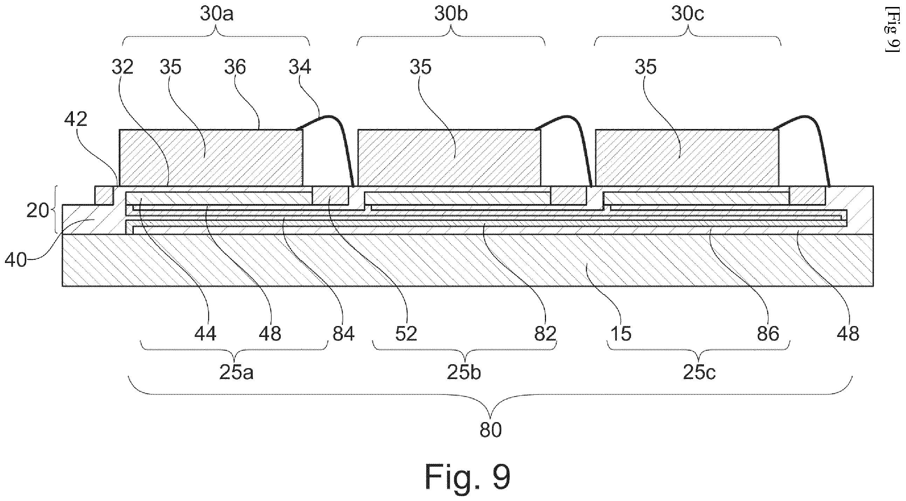

L'exemple de la figure 9 diffère de celui de la figure 3 en ce que qu'il comporte, en plus des diodes de dérivation pour chaque structure photovoltaïque 30a, 30b et 30c du module, dans la structure multicouche de connexion électrique 20 sous les diodes de dérivation 25a, 25b et 25c, une diode de blocage 80 des structures photovoltaïques 30a, 30b et 30c reliées en séries entre elles. La diode de blocage 80 comporte une couche semi-conductrice de blocage 82 s'étendant entre deux électrodes 84 et 86. Une des électrodes 82 est une extension de l'électrode 40 en surface de la structure multicouche de connexion électrique 20 sous la première structure photovoltaïque 30a de la série et l'autre électrode 84 est reliée électriquement à la dernière cellule de la série 30c par l'intermédiaire d'un conducteur électrique 34.

L'invention n'est pas limitée aux exemples qui viennent d'être décrit. Les différents éléments des modes de réalisations décrits ci-dessus peuvent être combinés entre eux sous réserve de leur compatibilité.

Par exemple, le module peut comporter des structures photovoltaïques différentes, notamment ayant un nombre de cellules différents.

Le module peut comporter une diode de blocage en complément de diode de dérivation protégeant des structures photovoltaïques de plusieurs cellules.

La portion semi-conductrice peut avoir tout autre forme tant qu'elle sépare les deux électrodes et qu'elle est reliée à ces dernières en inverse par rapport à la structure photovoltaïque.

La structure multicouche de connexion électrique peut comporter des fonctions additionnelles notamment des capteurs de température ou de tension.

Les cellules peuvent ne pas être toutes reliées en série, elles peuvent également être reliées entre elles en dérivation.

## Revendications

1. Module photovoltaïque (10) comportant :
- un substrat (15),
- une pluralité de structures photovoltaïques (30 ; 30a, 30b, 30c) reliées électriquement entre elles s'étendant sur le substrat (15) et comportant chacune au moins une cellule photovoltaïque (35 ; 35a, 35b, 35c, 35d), et
- une structure multicouche de connexion électrique (20) prise en sandwich entre le substrat (15) et la pluralité des structures photovoltaïques (30 ; 30a, 30b, 30c) formant au moins une diode de dérivation (25, 25a, 25b, 25c) pour chaque structure photovoltaïque (30 ; 30a, 30b, 30c),
chaque diode de dérivation (25, 25a, 25b, 25c) comportant :
- deux électrodes (40, 48) reliées électriquement à des bornes de polarité opposées de la structure photovoltaïque (30 ; 30a, 30b, 30c) correspondante, l'une au moins des deux électrodes (40, 48) s'étendant au moins partiellement sous la structure photovoltaïque (30 ; 30a, 30b, 30c) correspondante, et
- une portion semi conductrice (44) en contact avec les deux électrodes (40, 48) par deux surfaces (45, 46) distinctes,
dans lequel la portion semi-conductrice (44) de chaque diode de dérivation (25 ; 25a, 25b, 25c) est prise en sandwich entre les deux électrodes (40, 48) de la diode de dérivation correspondante pour former un empilement, chaque empilement s'étendant selon une surface parallèle au plan des structures photovoltaïques (30 ; 30a, 30b, 30c) supérieure ou égale à 50%, mieux supérieure ou égale à 80%, encore mieux supérieure ou égale à 90%, de la surface de la structure photovoltaïque..

2. Module selon la revendication 1, dans lequel au moins une structure photovoltaïque (30 ; 30a, 30b, 30c) comporte une unique cellule photovoltaïque (35 ; 35a, 35b, 35c, 35d).

3. Module selon la revendication 1 ou 2, dans lequel au moins une structure photovoltaïque (30 ; 30a, 30b, 30c) comporte un montage en série de plusieurs cellules photovoltaïques (35a, 35b, 35c, 35d), l'une des deux électrodes (40, 48) de la diode de dérivation (25 ; 25a, 25b, 25c) correspondante étant reliée électriquement à la première cellule photovoltaïque (35a) du montage en série, l'autre des deux électrodes (40, 48) de la diode de dérivation (25 ; 25a, 25b, 25c) correspondante étant reliée électriquement au moins à la dernière cellule photovoltaïque (35d) du montage en série.

4. Module selon l'une quelconque des revendications précédentes, dans lequel la structure multicouche de connexion électrique (20) est imprimée ou déposée autrement sur le substrat (15), notamment formée par impression, pulvérisation cathodique, dépôt laser pulsé, dépôt chimique en phase vapeur (CVD) ou (PECVD) ou encore dépôt de couche atomique (ALD).

5. Module selon l'une quelconque des revendications précédentes, dans lequel la portion semi-conductrice (44) de chaque diode de dérivation (25 ; 25a, 25b, 25c) est en contact avec une des électrodes (40, 48) par une première surface (45) sensiblement parallèle à un plan d'extension des structures photovoltaïques(30 ; 30a, 30b, 30c), et en contact avec l'autre des électrodes (40, 48) par une deuxième surface (46) opposée à la première.

6. Module selon l'une quelconque des revendications précédentes, dans lequel les deux électrodes (40, 48) de chaque diode de dérivation sont séparées entre elles uniquement par la portion semi-conductrice (44) de la diode de dérivation (25 ; 25a, 25b, 25c) correspondante ou les diodes de dérivation comportent chacune au moins une portion isolante (52) agencée pour séparer, avec la portion semi-conductrice (44), les deux électrodes (40, 48) entre elles.

7. Module selon l'une quelconque des revendications précédentes, dans lequel, pour chaque diode de dérivation (25 ; 25a, 25b, 25c), une des deux électrodes (40, 48) est reliée à la structure photovoltaïque (30 ; 30a, 30b, 30c) correspondante par au moins un interconnecteur métallique (34), notamment un fil ou un ruban métallique.

8. Module selon l'une quelconque des revendications précédentes, dans lequel, pour chaque diode de dérivation (25 ; 25a, 25b, 25c), une des deux électrodes (40, 48) est en contact direct avec la face arrière (32) de la structure photovoltaïque (30 ; 30a, 30b, 30c) correspondante,, ou le module comporte une couche conductrice séparant, pour chaque diode de dérivation (25 ; 25a, 25b, 25c), une des deux électrodes (40, 48) de la structure photovoltaïque (30 ; 30a, 30b, 30c), notamment une couche métallique rapportée ou directement formée sur l'électrode (40) ou une colle électriquement conductrice, notamment à base de silicone ou époxy

9. Module selon l'une quelconque des revendications précédentes, dans lequel une des deux électrodes (40, 48) de la diode de dérivation (25 ; 25a, 25b, 25c) pour chaque structure photovoltaïque (30 ; 30a, 30b, 30c), est une extension de l'une des deux électrodes (40, 48) de la diode de dérivation (25 ; 25a, 25b, 25c) pour une structure photovoltaïque (30 ; 30a, 30b, 30c) antérieur ou suivante.

10. Module selon l'une quelconque des revendications précédentes, dans lequel au moins deux structures photovoltaïques (30 ; 30a, 30b, 30c) sont reliées directement entre elles en série.

11. Module selon l'une quelconque des revendications précédentes, dans lequel au moins deux des structures photovoltaïques (30 ; 30a, 30b, 30c) sont reliées directement entre elles en parallèle.

12. Module selon l'une quelconque des revendications précédentes, dans lequel la structure multicouche de connexion électrique (20) comporte une diode de blocage (80) pour une pluralité de structures photovoltaïques (30a, 30b, 30c) montées entre elles en série, la diode de blocage (80) comportant deux électrodes de blocage (84, 86) reliées électriquement respectivement à des bornes de polarité opposés de la première (30a) et de la dernière structure photovoltaïque (30c) de la série, et une portion semi conductrice de blocage (82) en contact avec les deux électrodes de blocage (84, 86) par des surfaces différentes.

13. Procédé de fabrication d'un module selon l'une quelconque des revendications précédentes, le procédé comportant
- le dépôt des couches successives de la structure multicouche de connexion électrique (20) sur le substrat (15) pour former une pluralité de diodes de dérivation (25 ; 25a, 25b, 25c),
- l'adjonction de structures photovoltaïques (30 ; 30a, 30b, 30c) sur la structure multicouche de connexion électrique (20) de sorte que les structures photovoltaïques (30 ; 30a, 30b, 30c) se superposent chacune à une des diodes de dérivation (25 ; 25a, 25b, 25c),
- la liaison électrique, notamment par des interconnecteurs métalliques (34), des structures photovoltaïques (30 ;30a, 30b, 30c) entre elles, notamment par l'intermédiaire des diodes de dérivation (25a ; 25a, 25b, 25c) de sorte que les diodes de dérivation (25 ; 25a, 25b, 25v) soient passantes lorsque la structure photovoltaïque correspondante ne l'est pas.

14. Utilisation du module selon l'une quelconque des revendication 1 à 12 pour la fabrication de panneaux photovoltaïques, notamment destinés à une utilisation spatiale ou terrestre.
